# EUROPÄISCHE PATENTSCHRIFT

(11) **EP 1 856 734 B1**
(45) Veröffentlichungstag und Bekanntmachung des Hinweises auf die Patenterteilung: **14.04.2010**
(21) Anmeldenummer: 06701031.4
(22) Anmeldetag: 16.01.2006
(51) Int. Cl.: H01L 23/473, H01L 23/467, H01L 23/427

(54) **MIKROWÄRMEÜBERTRAGER**
MICRO-HEAT EXCHANGER
MICRO-ECHANGEUR DE CHALEUR

(30) Priorität: 22.02.2005 DE 102005008271
(43) Veröffentlichungstag der Anmeldung: 21.11.2007
(73) Patentinhaber: Behr GmbH & Co. KG, 70469 Stuttgart (DE)
(72) Erfinder: ZWITTIG, Eberhard, 73269 Hochdorf (DE)
(74) Vertreter: Grauel, Andreas
(86) Internationale Anmeldenummer: PCT/EP2006/000307
(87) Internationale Veröffentlichungsnummer: WO 2006/089597

(56) Entgegenhaltungen:
- WO-A-03/080233
- DE-A1- 4 315 580
- DE-A1- 10 246 990
- DE-A1- 19 608 824
- DE-C1- 19 801 374

## Beschreibung

Die Erfindung betrifft einen Mikrowärmeübertrager nach dem Oberbegriff des Patentanspruches 1.

Mikrowärmeübertrager sind Wärmeübertrager mit einer Fein- oder Feinststruktur von Kanälen, d. h. Mikrokanälen, deren Abmessungen im Submillimeterbereich liegen. Man erzielt dadurch auf kleinstem Raum eine große Oberfläche für die Wärmeübertragung. Derartige Mikrowärmeübertrager werden z. B. - wie in der DE 100 17 971 A1 beschrieben - für die Kühlung von Bauelementen der Leistungselektronik eingesetzt.

Bekannte Mikrowärmeübertrager sind aus einer Vielzahl von übereinander gestapelten Platten aufgebaut, in welche die Mikrokanäle durch geeignete Bearbeitungsverfahren eingebracht werden. In der DE 37 09 278 A1 werden die Mikrokanäle in Form von Nuten im Bereich von Hundertstel Millimetern spanabhebend mit Formdiamanten eingearbeitet. Die Kanäle verlaufen dabei durchgehend von einer Seite bis zur gegenüber liegenden Seite eines Plattenelementes, d. h. die Kanäle sind nach oben und zu den Seiten hin offen. Bei einem Stapel derartiger Platten sind die Anschlüsse für das Strömungsmedium daher seitlich angeordnet und gegenüber den Seitenflächen abgedichtet.

Durch die DE 198 01 374 C1 wurde eine ähnliche Bauart eines Mikrowärmeübertragers bekannt, allerdings mit größeren Abmessungen, d. h. Kanaltiefen von 0,1 bis 0,4 mm, Kanalbreiten von 0,1 bis 10 mm und Stegbreiten von 0,1 bis 10 mm. Die Kanäle sind in Bleche eingearbeitet und treten seitlich aus den Blechen bzw. seitlich aus einem durch Aufeinanderschichten der Bleche erzeugten Stapel aus. Die Bleche werden durch Löten miteinander verbunden und bilden somit einen Mikrowärmeübertragerblock, der beispielsweise als Kreuzstromwärmeübertrager ausgebildet ist.

Nachteilig bei den bekannten Mikrowärmeübertragern ist die seitliche Anordnung der Anschlüsse für das Kühlmedium oder die Strömungsmedien.

Es ist Aufgabe der vorliegenden Erfindung, einen Mikrowärmeübertrager der eingangs genannten Art in vereinfachter Bauweise und mit gesteigerter Wärmeübertragungsleistung zu schaffen.

Diese Aufgabe wird durch die Merkmale des Patentanspruches 1 gelöst. Erfindungsgemäß ist vorgesehen, dass die Kanäle (Mikrokanäle) in ein plattenförmiges Matrixelement von beiden Plattenseiten eingebracht werden, so dass die Kanäle seitlich abgeschlossen sind. Das Strömungsmedium kann somit entweder nur von oben oder von unten oder - im Falle dass zwei Strömungsmedien vorgesehen sind - von oben und unten in die Kanäle des Matrixelementes eintreten. Das Matrixelement ist mit den Kanälen bzw. Kanalwänden einstückig ausgebildet, wobei die Kanäle durch bekannte spangebende oder spanlose Verfahren in das Matrixelement eingebracht werden können, z. d. Fräsen mit einem Scheiben- oder Fingerfräser, durch Räumen, durch Hochdruckumformung oder auch durch Druck- und/oder Spritzgießen. Die Anschlüsse für das bzw. die Strömungsmedien sind somit vorzugsweise auf der Oberseite oder auf beiden Seiten angeordnet.

In vorteilhafter Ausgestaltung der Erfindung ist ein solches Matrixelement nach oben und/oder nach unten durch eine Deckplatte abgeschlossen. Die Deckplatte schließt somit die offenen Kanäle ab und kann durch Löten oder Kleben mit dem Matrixelement verbunden werden.

In weiterer vorteilhafter Ausgestaltung der Erfindung sind in den Deckplatten Verteilerkanäle integriert, welche mit den (Mikro-)Kanälen kommunizieren, das Strömungsmedium sammeln bzw. verteilen und mit einem Strömungsmittelanschluss verbinden. Derartige Mikrowärmeübertrager mit nur einem Strömungsmedium, einem Kühlmedium, können beispielsweise zur Kühlung von elektronischen Bauelementen eingesetzt werden, wobei die glatte Unterseite des Matrixelementes wärmeleitend mit dem Gehäuse der Elektronikbaueinheit verbunden ist, während durch die auf der Oberseite angeordneten Mikrokanäle ein Kühlmittel, beispielsweise ein Wasser-Glykol-Gemisch strömt. Insbesondere bei diesem Verwendungszweck ist die Anordnung der Kühlmittelanschlosse auf der Oberseite besonders vorteilhaft.

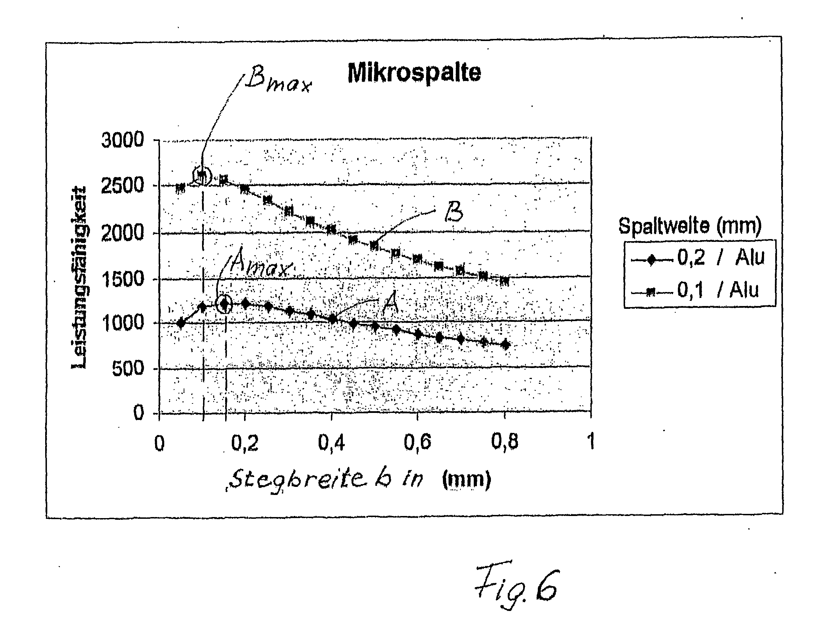

Nach einer vorteilhaften Weiterbildung der Erfindung ist die Geometrie der Mikrokanäle durch besondere Abmessungen gekennzeichnet, wobei die Kanal- bzw. Spaltweite bevorzugt in einem Bereich von 0,1 bis 0,3 mm, insbesondere von 0,1 bis 0,2 mm, die Kanalhöhe in einem Bereich von 2 bis 5 mm, insbesondere von 3 bis 5 mm liegt. Der Kanalquerschnitt ist also rechteckförmig ausgebildet, wobei das Verhältnis der beiden Seitenlängen in einem Bereich von 15 bis 50 liegt. Durch diese Kanalgeometrie ergibt sich eine große Wärmeaustauschfläche auf geringem Raum und damit eine hohe Wärmeübertragungsleistung. Vorteilhafterweise weisen die Stege, die jeweils zwischen den Mikrokanälen bzw. Mikrospalten angeordnet sind eine Stegbreite im Bereich von 0,1 bis 0,8 mm, vorzugsweise im Bereich von 0,1 bis 0,2 mm auf - für diesen letzteren Bereich ergibt sich eine maximale Wärmeübertragungsleistung (vgl. hierzu auch Diagramm gemäß Fig. 6).

Nach einer vorteilhaften Weiterbildung der Erfindung sind die Matrixelemente zu einem Stapel übereinander geschichtet, wobei die Mikrokanäle miteinander in Strömungsverbindung stehen und beispielsweise parallel oder hintereinander geschaltet sind. Der Stapel ist nach oben durch ein Deckblech und nach unten durch ein Bodenblech abgeschlossen und abgedichtet. Sofern die einzelnen Matrixelemente Kanäle auf ihrer Ober- und ihrer Unterseite aufweisen, sind zwischen den Matrixelementen Zwischenbleche angeordnet, die ein Matrixelement gegenüber dem benachbarten und damit gegenüber dem anderen Fluid abdichten. Auch bei dieser Stapelbauart sind die Strömungsmittelanschlüsse auf der Oberseite angeordnet.

Als Werkstoffe für das Matrixelement beziehungsweise die Deckplatte können Metalle, Legierungen, Kunststoffe oder Keramiken zum Einsatz kommen.

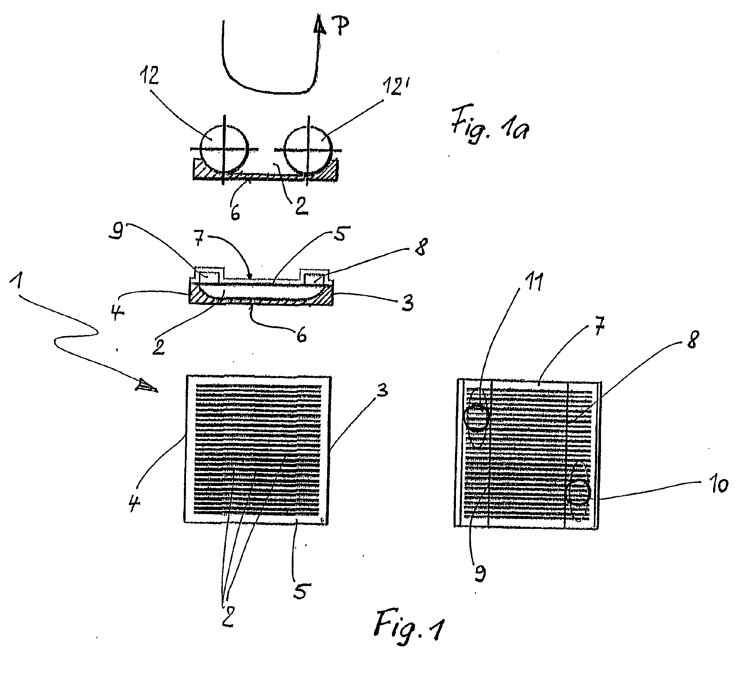

Ausführungsbeispiele der Erfindung sind in der Zeichnung dargestellt und werden im Folgenden näher beschrieben. Es zeigen
- Fig. 1: ein Biespiel eines Matrixelementes mit einseitig angeordneten Mikrokanälen für ein Strömungsmedium,
- Fig. 1 a: ein Verfahren zur Herstellung der Mikrokanäle in dem Matrixelement gemäß Fig. 1,
- Fig. 2: ein Ausführungsbeispiel eines erfindungemäßen Matrixelementes mit wechselseitig angeordneten Kanälen für zwei Strömungsmedien,
- Fig. 3: ein Beispiel für ein Matrixelement mit integrierten Verteilerkanälen,
- Fig. 3a: einen Querschnitt durch die Matrix und die Strömungskanäle,
- Fig. 4: den Querschnitt in der Ebene IV-IV in vergrößerter Darstellung mit Kanalgeometrie,
- Fig. 5: einen Mikrowärmeübertrager für zwei Strömungsmedien, aufgebaut aus einzelnen Matrixelementen und
- Fig. 6: ein Diagramm mit Darstellung der Wärmeübertragungsleistung in Abhängigkeit von der Kanalweite und der Stegbreite.

Fig. 1 zeigt ein plattenförmiges, quadratisch ausgebildetes Matrixelement 1 mit einer Vielzahl von parallel zueinander angeordneten Mikrokanälen 2, welche in ihrer Länge durch Seitenwände 3, 4 des Matrixelementes 1 begrenzt, d. h. nach außen abgeschlossen sind. Das Matrixelement 1 weist eine Oberseite 5 auf, zu der die Kanäle 2 offen sind. Die Unterseite 6 des Matrixelementes ist glatt ausgebildet. Die offene Oberseite 5 des Matrixelementes 1 ist durch einen Deckel 7 abgeschlossen, in welchem seitlich und parallel zu den Seitenflächen 3, 4 angeordnete Verteilerkanäle 8, 9 angeordnet sind. In den Verteilerkanälen 8, 9 sind Strömungsmittelanschlüsse 10, 11 angeordnet, über welche ein Strömungsmittel zu- und abgeführt wird. Das Strömungsmittel, z. B. ein Kühlmedium wird also über einen Verteilerkanal 8 (oder 9) auf die einzelnen Mikrokanäle 2 verteilt, durchströmt das Matrixelement 1 und wird im anderen Strömungskanal 9 (oder 8) gesammelt und nach außen abgeführt. Ein derartiges Matrixelement kann beispielsweise als Kühlvorrichtung zur Kühlung von elektronischen Bauteilen verwendet werden, indem die glatte Unterseite 6 auf einer entsprechenden nicht dargestellten Fläche des Elektronikbauteils wärmeleitend befestigt wird. Die entstehende Wärme wird dann über das durch die Kanäle 2 strömende Kühlmedium, z. B. ein Wasser-Glykol-Gemisch abgeführt.

Fig. 1a zeigt eine Möglichkeit zur Herstellung der Mikrokanäle 2: dazu wird ein scheibenförmiger Fräser 12 ein eine Anfangsposition gebracht, wobei eine Zustellung senkrecht zur Oberseite 5 erfolgt. Nach Erreichen der erforderlichen Kanalhöhe bzw. -tiefe wird der Scheibenfräser 12 in der Zeichnung nach rechts in die Endstellung 12' bewegt, und zwar parallel zur Ober- bzw. Unterseite 5, 6 und danach senkrecht aus dem Kanal 2 herausgezogen. Die Zustell- und Vorschubbewegung des Fräsers 12, 12' ist durch einen Pfeil P dargestellt. Wegen der Vielzahl der parallel zueinander verlaufenden Kanäle 2 kann der Fräser 12 als Walze, bestehend aus einer Vielzahl von einzelnen Scheiben bestehen. Durch dieses Verfahren ist sichergestellt, dass die Seitenwände 3, 4 stehen bleiben und die Kanäle 2 somit stirnseitig abgeschlossen sind. Das Matrixelement 1 mit den Kanälen 2 ist somit einstückig ausgebildet. Die Deckplatte 7 kann stoffschlüssig, z. B. durch Kleben, Löten oder Schweißen oder durch Verschrauben mit dem Matrixelement 1 verbunden werden.

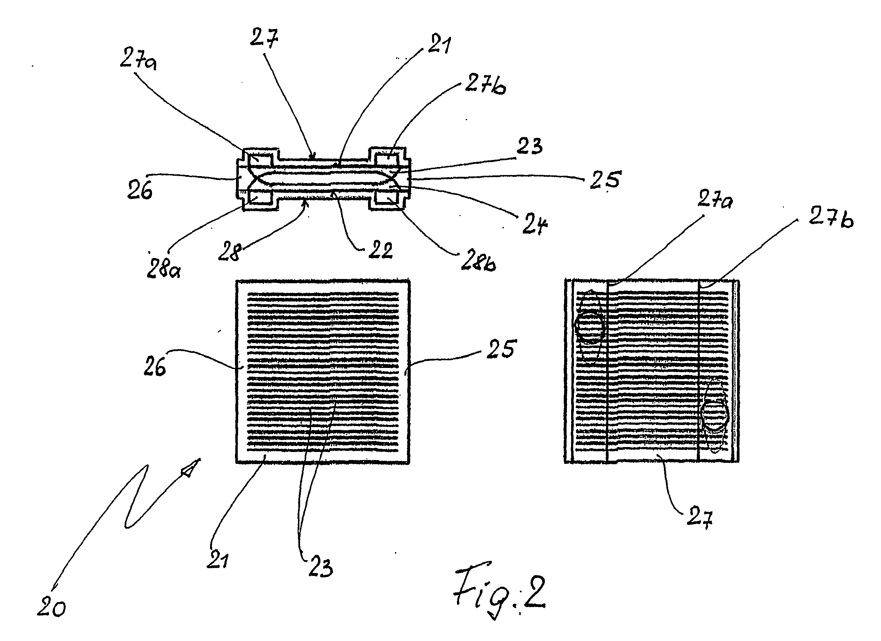

Fig. 2 zeigt ein erstes Ausführungsbeispiel der Erfindung für ein Matrixelement 20, welches eine Oberseite 21 und eine Unterseite 22 aufweist, in welche jeweils Kanäle 23, 24 eingebracht sind, welche in ihrer Ausbildung den zu Fig. 1 beschriebenen Kanälen 2 entsprechen. Die Kanäle 21, 22 sind somit seitlich durch Seitenwände 25, 26 geschlossen. Die offene Oberseite 21 und die offene Unterseite 22 sind jeweils durch eine Deckplatte 27 mit Verteilerkanälen 27a, 27b und eine Deckplatte 28 mit Verteilerkanälen 28a, 28b abgeschlossen. Das Matrixelement 20 kann somit von zwei Strömungsmedien im Gleich- oder Gegenstrom durchströmt werden, wobei sich entsprechende nicht bezeichnete Strömungsmittelanschlüsse im Bereich der Verteilerkanäle 27a, 27b, 28a, 28b befinden.

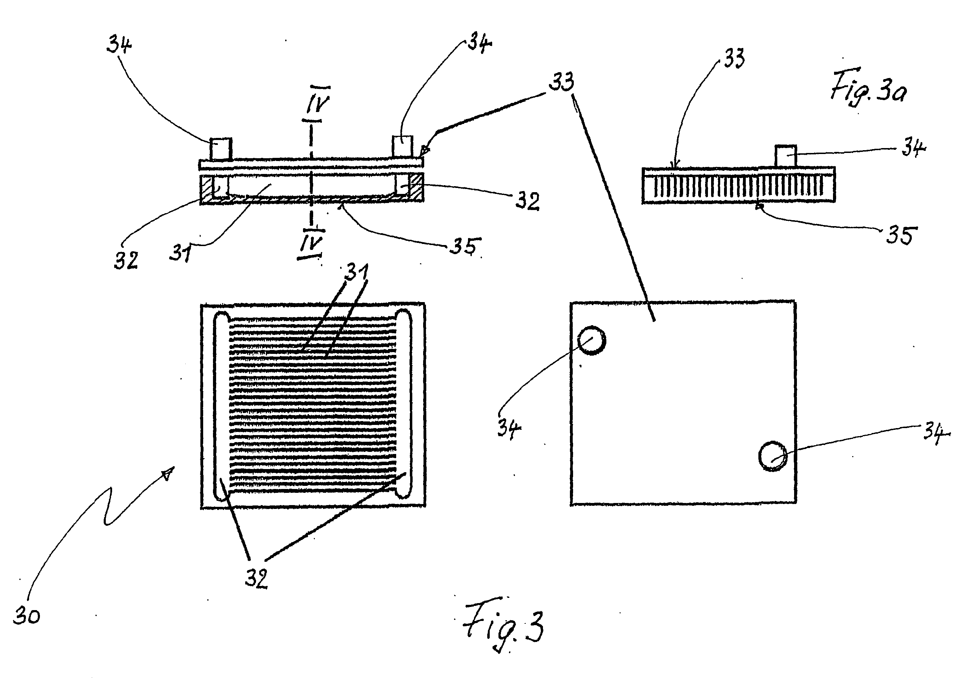

Fig. 3 zeigt ein Beispiel für ein Matrixelement 30 mit Strömungskanälen 31, denen stirnseitig Verteilerkanäle 32 zugeordnet sind. Die nach einer Seite offenen Kanäle 31 werden durch eine Deckplatte 33 abgeschlossen, die im Bereich der Verteilerkanäle 32 Strömungsmittelanschlüsse 34 aufweist. Der Boden 35 des Matrixelementes 30 ist nach außen glatt ausgebildet. Insofern kann auch dieses Matrixelement 30 vorteilhaft für die Kühlung von elektronischen Bauteilen, z. B. eines PC-Prozessors eingesetzt werden.

Fig. 3a zeigt einen Querschnitt durch das Matrixelement 30 mit Deckel 33.

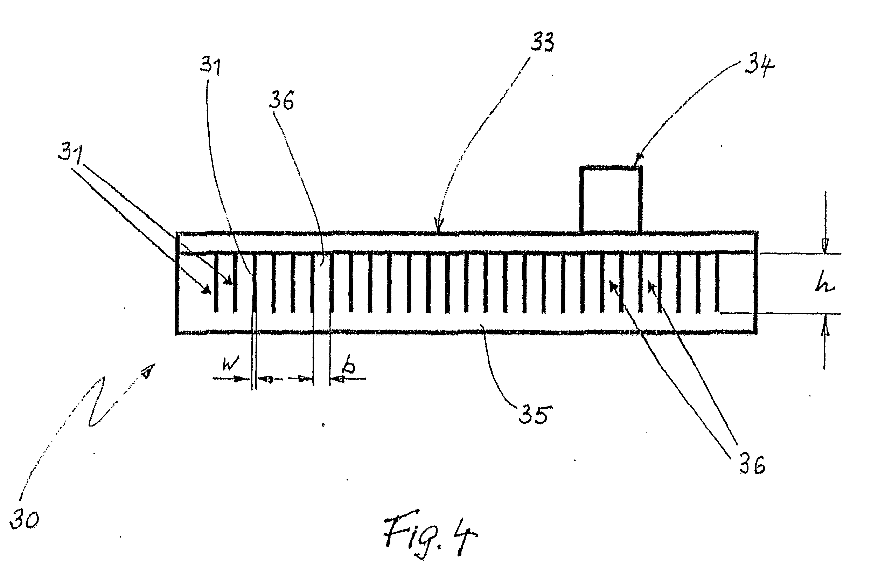

Fig. 4 zeigt den in Fig. 3a dargestellten Schnitt in der Ebene IV-IV. Von dem nach außen glatten, durchgehenden Bodenbereich 35 erstrecken sich nach oben, d. h. in Richtung Deckel 33 die als Mikrospalte ausgebildeten Strömungskanäle 31, die eine Höhe h und eine Kanal- bzw. Mikrospaltweite w aufweisen. Zwischen den Mikrospalten 31 sind Stege 36 mit einer Stegbreite b angeordnet - die Stegbreite b entspricht also dem Abstand benachbarter Mikrospalte 31. Die Stege 36 sind einstückig mit dem Bodenbereich 35 ausgebildet. Bei einem Beispiel ist die Spaltweite w im Bereich von 0,1 bis 0,2 mm gewählt, während die Höhe der Mikrospalte 31 (Kanäle) h im Bereich von 3 bis 5 mm liegt. Damit ergibt sich ein Verhältnis von Spalthöhe zu Spaltweite in einem Bereich von 15 bis 50. Die Stegbreite b liegt bevorzugt in einem Bereich von 0,1 bis 0,8 mm, insbesondere in einem Bereich von 0,1 bis 0,2 mm. Mit dieser Spaltgeometrie wird eine Wärmeleistung erzielt, wie sie in Fig. 6 als Diagramm dargestellt ist.

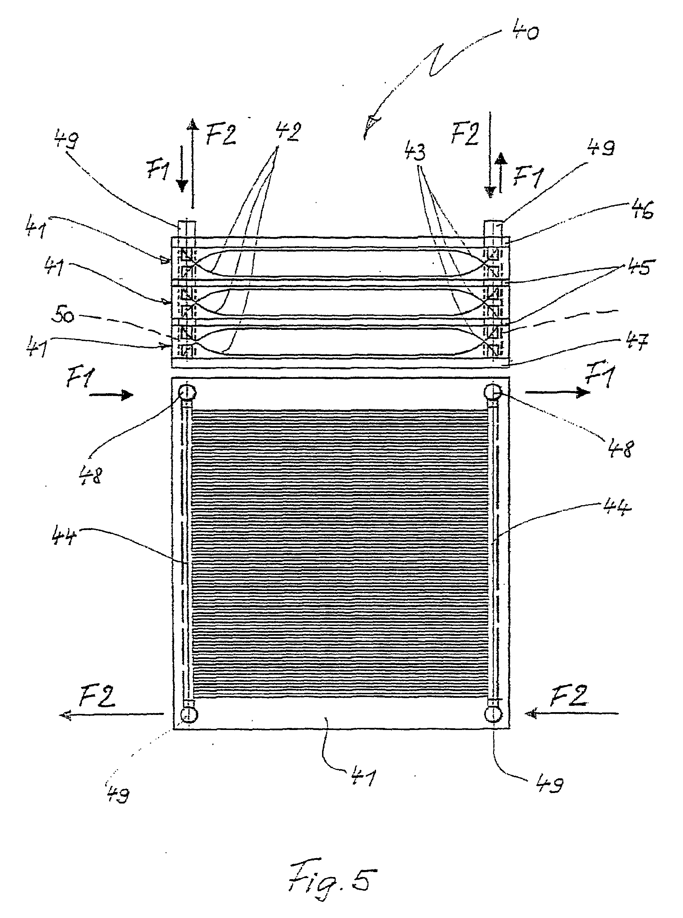

Fig. 5 zeigt ein weiteres Ausführungsbeispiel der Erfindung in Form eines Mikrowärmeübertragers 40, der aus einzelnen übereinander angeordneten Matrixelementen 41 aufgebaut ist. Die Matrixelemente 41 weisen Mikrokanäle 42 auf der Oberseite und Mikrokanäle 43 auf der Unterseite auf und sind jeweils stirnseitig mit in ein Matrixelement 41 integrierten Verteilerkanälen 44 verbunden. Zwischen den Matrixelementen 41 sind Zwischenbleche 45 angeordnet, welche jeweils die Kanäle der Ober- und der Unterseite von benachbarten Matrixelementen 41 voneinander trennen. Der Stapel von Matrixelementen 41 ist nach oben durch ein Deckblech 46 und nach unten durch ein Bodenblech 47 abgeschlossen. Der Mikrowärmeübertrager 40 wird von zwei Medien durchströmt, welche über die Anschlüsse 48, 49 ein- bzw. austreten. Die einzelnen Matrixelemente 41 bzw. ihre unterschiedliche Medien führenden Kanäle 42, 43 sind untereinander durch gestrichelt dargestellte Querbohrungen 50 in den Matrixelementen 41 und in den Zwischenblechen 45 miteinander verbunden. Die Ein- und Austritte der beiden Medien sind durch Pfeile F1, F2 (Fluid 1, Fluid 2) gekennzeichnet. Alle Teile können stoffschlüssig miteinander zu einem Block verbunden werden.

Fig. 6 zeigt ein Diagramm, bei welchem die Leistungsfähigkeit der Mikrospalte (vgl. Mikrospalt 31 in Fig. 4) über der Stegbreite b aufgetragen ist. Ein erster unterer Kurvenast A zeigt die Leistungsfähigkeit bei einer Spaltweite w = 0,2 mm für einen Aluminiumwerkstoff. Ein zweiter oberer Kurvenast B zeigt die Leistungsfähigkeit eines erfindungsgemäßen Mikrowärmeübertragers mit Mikrospalten mit der Spaltweite w = 0,1 mm, ebenfalls für einen Aluminiumwerkstoff. Der Vergleich beider Kurvenäste A, B zeigt, dass beide ein Maximum Aₘₐₓ und Bₘₐₓ aufweisen, die gegeneinander auf der X-Achse verschoben sind: somit ergibt sich das Maximum Bₘₐₓ für eine Spaltweite von ca. 0,1 mm, während das Maximum Aₘₐₓ bei einer größeren Stegbreite von ca. 0,15 mm liegt. Man kann also sagen, dass die Spaltweite w mit der Stegbreite b korreliert, d. h. eine geringe Spaltweite bei großer Stegbreite erbringt kein Maximum. Vielmehr muss die Stegbreite b im Bereich der Spaltweiten liegen, damit sich Maxima für die Leistungsfähigkeit ergeben.

## Patentansprüche

1. Mikrowärmeübertrager mit einer Mikrostruktur von Kanälen, die in mindestens einem plattenförmigen Matrixelement (20,41) angeordnet und von mindestens einem. Wärmeträgermedium durchströmbar sind, wobei das Matrixelement (20,41) eine Ober- und eine wobei Unterseite (31,22) sowie Seitenflächen (25,26) aufweist, die Kanäle (23,24,42,43) jeweils in die Oberseite und die Unterseite eingebracht sind und die Kanäle (23,42) in der Oberseite zur Oberseite Offen und die kanäle (24,43) in der Unterseite zur Unterseite offen sind, **dadurch gekennzeichnet, daß** alle Kanäle zu den Seitenflächen geschlossen ausgebildet sind.

2. Mikrowärmeübertrager nach Anspruch 1, **dadurch gekennzeichnet, dass** den Kanälen (23, 24, 42, 43) Verteilerkanäle (27a, 27b, 28a, 28b) und Anschlüsse für den Zufluss und den Abfluss des Wärmeträgermediums zugeordnet sind.

3. Mikrowärmeübertrager nach Anspruch 2, **dadurch gekennzeichnet, dass** die Anschlüsse auf der Oberseite (21) und auf der Unterseite (22) angeordnet sind.

4. Mikrowärmeübertrager nach Anspruch 2, oder 3, **dadurch gekennzeichnet, dass** die Ober- und/oder Unterseite (21, 22) des mindestens einen Matrixelementes (20, 41) durch eine Deckplatte (27, 28) dicht abgeschiossen ist.

5. Mikrowärmeübertrager nach Anspruch 4, **dadurch gekennzeichnet, dass** die Verteilerkanäle (27a, 27b, 28a, 28b) in die Deckplatten (27, 28) integriert sind.

6. Mikrowärmeübertrager nach mindestens einem der Ansprüche 1 bis 5, **dadurch gekennzeichnet, dass** die Kanäle (23, 24) durch spangebende oder spanlose Bearbeitung in das mindestens eine Matrixelement (20, 30) eingebracht werden.

7. Mikrowärmeübertrager nach mindestens einem der Ansprüche 1 bis 6, **dadurch gekennzeichnet, dass** die Kanäle eine Kanalweite bzw. Mikrospaltweite w aufweisen, wobei folgende Abmessungen gelten: 0,1 ≤ w ≤ 0,3 mm, vorzugsweise 0,1 ≤ w ≤ 0,2 mm.

8. Mikrowärmeübertrager nach mindestens einem der Ansprüche 1 bis 7, **dadurch gekennzeichnet, dass** die Kanäle eine Kanalhöhe h aufweisen, wobei folgende Abmessungen gelten: 2 ≤ h ≤ 5 mm.

9. Mikrowärmeübertrager nach mindestens einem der Ansprüche 1 bis 8, **dadurch gekennzeichnet, dass** zwischen den Kanälen Stege mit einer Stegbreite b angeordnet sind, wobei folgende Abmessungen gelten: 0,1 ≤w≤0,8 mm, vorzugsweise 0,1 ≤ b ≤ 0,2 mm.

10. Mikrowärmeübertrager nach Anspruch 7, 8, und 9, **dadurch gekennzeichnet, dass** die Spaltweite w und die Stegbreite b jeweils in einem Bereich von 0,1 bis 0,2 mm liegen.

11. Mikrowärmeübertrager nach mindestens einem der Ansprüche 1 bis 10, **dadurch gekennzeichnet, dass** mehrere Matrixelemente (41) übereinander angeordnet sind und einen Stapel (40) bilden, wobei die Kanäle (42, 43) über Strömungsverbindungen (44, 50) miteinander kommunizieren.

12. Mikrowärmeübertrager nach Anspruch 11, **dadurch gekennzeichnet, dass** zwischen den Matrixelementen (41) eines Stapels (40) Zwischenbleche (45) angeordnet sind.

13. Mikrowärmeübertrager nach Anspruch 12, **dadurch gekennzeichnet, dass** der Stapel (40) nach oben durch ein Deckblech (46) mit Anschlüssen (48, 49) für die Wärmeträgermedien und nach unten durch ein Bodenblech (47) abgeschlossen ist.

## Claims

1. A micro-heat exchanger with a microstructure of channels that are arranged in at least one plate-shaped matrix element (20, 41) and through which at least one heat transfer medium circulates, wherein the matrix element (20, 41) has an upper side and a lower side (21, 22), as well as lateral surfaces (25, 26), wherein channels (23, 24, 42, 43) are respectively brought into the upper side and the lower side, and the channels (23, 42) in the upper side are open toward the upper side, and the channels (24, 43) in the lower side are open toward the lower side, **characterised by** the fact that all channels (2, 23, 24) are closed at the lateral surfaces (3, 4).

2. The micro-heat exchanger according to claim 1, **characterised by** the fact that distribution channels (27a, 27b, 28a, 28b) and connections for the inflow and outflow of the heat transfer medium are assigned to the channels (23, 24, 42, 43).

3. The micro-heat exchanger according to claim 2, **characterised by** the fact that the connections are arranged on the upper side (21) and on the lower side (22).

4. The micro-heat exchanger according to claim 2 or 3, **characterised by** the fact that the upper side and/or lower side (21, 22) of the at least one matrix element (20, 41) is tightly closed with a cover plate (27, 28).

5. The micro-heat exchanger according to claim 4, **characterised by** the fact that the distribution channels (27a, 27b, 28a, 28b) are integrated into the cover plates (27, 28).

6. The micro-heat exchanger according to at least one of claims 1 to 5, **characterised by** the fact that that the channels (23, 24) are brought in the at least one matrix element (20, 30) by means of cutting or non-cutting processing.

7. The micro-heat exchanger according to at least one of claims 1 to 6, **characterised by** the fact that the channels (31) have a channel width or microgap width w, wherein the following dimensions apply: 0.1 ≤ w ≤ 0.3 mm, preferably 0.1 ≤ w ≤ 0.2 mm.

8. The micro-heat exchanger according to at least one of claims 1 to 7, **characterised by** the fact that the channels have a channel height h, wherein the following dimensions apply: 2 ≤ h ≤ 5 mm.

9. The micro-heat exchanger according to at least one of claims 1 to 8, **characterised by** the fact that ridges with a ridge width b are arranged between the channels, wherein the following dimensions apply: 0.1 ≤ w ≤ 0.8 mm, preferably 0.1 ≤ b ≤ 0.2 mm.

10. The micro-heat exchanger according claim 7, 8 and 9, **characterised by** the fact that the gap width w and the ridge width b respectively lie in the range of 0.1 to 0.2 mm.

11. The micro-heat exchanger according to at least one of claims 1 to 10, **characterised by** the fact that several matrix elements (41) are arranged one on top of another and form a stack (40), wherein the channels (42, 43) communicate with one another via fluidic connections (44, 50).

12. The micro-heat exchanger according to claim 11, **characterised by** the fact that intermediate sheets (45) are arranged between the matrix elements (41) of a stack (40).

13. The micro-heat exchanger according to claim 12, **characterised by** the fact that the stack (40) is closed at the top with a cover sheet (46) featuring connections (48, 49) for the heat transfer media and at the bottom with a bottom sheet (47).

## Revendications

1. Micro-échangeur de chaleur comprenant une microstructure de conduits qui sont disposés dans au moins un élément de matrice (20, 41) en forme de plaque et traversés par au moins un milieu d'échangeur de chaleur, où l'élément de matrice (20, 41) présente une partie supérieure et une partie inférieure (21, 22) ainsi que des surfaces latérales (25, 26), où les conduits (23, 24, 42, 43) sont introduits respectivement dans la partie supérieure et la partie inférieure, et les conduits (23, 42) situés dans la partie supérieure sont ouverts vers la partie supérieure, et les conduits (24, 43) situés dans la partie inférieure sont ouverts vers la partie inférieure, **caractérisé en ce que** tous les conduits sont configurés en étant fermés vers les surfaces latérales.

2. Micro-échangeur de chaleur selon la revendication 1, **caractérisé en ce que** des conduits de distribution (27a, 27b, 28a, 28b) et des raccords prévus pour l'arrivée et l'évacuation du milieu traversant l'échangeur de chaleur sont associés aux conduits (23, 24, 42, 43).

3. Micro-échangeur de chaleur selon la revendication 2, **caractérisé en ce que** les raccords sont disposés sur la partie supérieure (21) et sur la partie inférieure (22).

4. Micro-échangeur de chaleur selon la revendication 2 ou 3, **caractérisé en ce que** la partie supérieure et / ou inférieure (21, 22) de l'élément de matrice (20, 41) au moins au nombre de un est obturée de façon étanche par une plaque de recouvrement (27, 28).

5. Micro-échangeur de chaleur selon la revendication 4, **caractérisé en ce que** les conduits de distribution (27a, 27b, 28a, 28b) sont intégrés dans les plaques de recouvrement (27, 28).

6. Micro-échangeur de chaleur selon au moins l'une quelconque des revendications 1 à 5, **caractérisé en ce que** les conduits (23, 24) sont introduits dans l'élément de matrice (20, 30) au moins au nombre de un, par usinage avec enlèvement de matière ou sans enlèvement de matière.

7. Micro-échangeur de chaleur selon au moins l'une quelconque des revendications 1 à 6, **caractérisé en ce que** les conduits présentent une largeur de conduit ou une micro-ouverture w, où les dimensions qui s'appliquent sont les suivantes : 0,1 mm ≤ w ≤ 0,3 mm, de préférence 0,1 mm ≤ w ≤ 0,2 mm.

8. Micro-échangeur de chaleur selon au moins l'une quelconque des revendications 1 à 7, **caractérisé en ce que** les conduits présentent une hauteur de conduit h où les dimensions qui s'appliquent sont les suivantes : 2 mm ≤ h ≤ 5 mm.

9. Micro-échangeur de chaleur selon au moins l'une quelconque des revendications 1 à 8, **caractérisé en ce que** des parties pleines, ayant une largeur de partie pleine b, sont disposées entre les conduits, où les dimensions qui s'appliquent sont les suivantes : 0,1 mm ≤ w ≤ 0,8 mm, de préférence 0,1 mm ≤ b ≤ 0,2 mm.

10. Micro-échangeur de chaleur selon les revendications 7, 8 et 9, **caractérisé en ce que** l'ouverture w et la largeur de partie pleine b se situent respectivement dans une plage comprise entre 0,1 mm et 0,2 mm.

11. Micro-échangeur de chaleur selon au moins l'une quelconque des revendications 1 à 10, **caractérisé en ce que** plusieurs éléments de matrice (41) sont disposés les uns au-dessus des autres et forment une pile (40), où les conduits (42, 43) communiquent entre eux par des passages d'écoulement (44, 50).

12. Micro-échangeur de chaleur selon la revendication 11, **caractérisé en ce que** des tôles intermédiaires (45) sont disposées entre les éléments de matrice (41) d'une pile (40).

13. Micro-échangeur de chaleur selon la revendication 12, **caractérisé en ce que** la pile (40) est obturée, vers le haut, par une tôle de recouvrement (46) comportant des raccords (48, 49) prévus pour les milieux traversant l'échangeur de chaleur et, vers le bas, par une tôle de fond (47).
